Europäisches Patentamt

European Patent Office

Office européen des brevets

(19)

(11) Publication number: **0 052 565**

**A1**

(12) # EUROPEAN PATENT APPLICATION

(21) Application number: **81401793.5**

(22) Date of filing: **13.11.81**

(51) Int. Cl.³: **H 03 K 19/092**

(30) Priority: **17.11.80 US 207329**

(43) Date of publication of application:
**26.05.82 Bulletin 82/21**

(84) Designated Contracting States:
**DE FR GB IT NL**

(71) Applicant: **FAIRCHILD CAMERA & INSTRUMENT CORPORATION
464 Ellis Street
Mountain View California 94042(US)**

(72) Inventor: **Yin, Patrick Y.C.
1853 Cape Hatteras Way
San Jose California 95133(US)**

(74) Representative: **Chareyron, Lucien et al,
Schlumberger Limited 42, rue Saint-Dominique
F-75340 Paris Cedex 07(FR)**

(54) Temperature and process variation compensated TTL to ECL translator buffer.

(57) A temperature and process variation compensated TTL to ECL translator buffer includes an input voltage translator (2) and a reference voltage translator (14) formed on the same integrated circuit chip by the same process steps. The input voltage translator (2) and the reference voltage translator (14) each include the same number of forward biased diode voltage drops and base emitter voltage drops during operation and each forward biased junction is operated at the same current density to cause the input voltage translator (2) and the reference voltage translator (14) to be equally affected by process and temperature variations thereby compensating for the variations.

FIG. I

EP 0 052 565 A1

# TEMPERATURE AND PROCESS VARIATION COMPENSATED
## TTL TO ECL TRANSLATOR BUFFER

by

### Patrick Y. C. Yin

## BACKGROUND OF THE INVENTION

### 1.   Field of the Invention

The present invention relates generally to a translator for interfacing data and control signals between sections of digital systems having different voltage threshold requirements and more particularly, to a translator circuit for interfacing transistor-to-transistor logic (TTL) level data and control signals to emitter coupled logic (ECL) level data and control signals.

### 2.   Description of the Prior Art

In digital systems comprised of several discrete logic sections, it is important that the sections be able to communicate with other sections in a predictable and constant manner under all adverse conditions, i.e., input threshold sensitivities for required translators and switching characteristics should be invariant as a function of supply voltage, ambient temperature, or semiconductor process parameters. Although prior art circuits have long been provided with means to compensate for changes in a circuit component characteristic caused by temperature, process or voltage variations as disclosed, for example, in U.S. patent 3,781,648 and INTEGRATED ELECTRONICS:  ANALOG AND DIGITAL CIRCUITS AND SYSTEMS, Jacob Millman and Christos Halkias, McGraw Hill Book Company, 1972, no means has heretofore been

provided to compensate for the cumulative temperature, voltage and process variation induced effects on threshold sensitivity and switching performance of a voltage translator by intentionally causing reference voltage translation variations to track input voltage translation variations.

## SUMMARY OF THE INVENTION

It is therefore a principal object of the present invention to provide a translator circuit for translating voltage levels of data and control signals from one voltage level to another voltage level independent of process variation and temperature variations.

The circuit of the present invention includes an input voltage translator coupled to receive a first voltage level to be translated and a reference voltage translator coupled to receive a reference voltage corresponding to a desired switching threshold. The input voltage translator and the reference voltage translator are formed on the same integrated circuit chip by the same process steps. The input voltage translator and the reference voltage translator each include the same number of forward biased diode voltage drops and base emitter drops during operation and each is operated at the same current density to cause the input voltage translation and the reference voltage translation to be equally affected by process and temperature variations, current density being effective emitter area divided by emitter current. The input voltage translator translates the applied input voltage and the reference voltage translator translates the reference voltage downward by an equal voltage amount. The output of the input voltage translator and the output of the reference voltage translator are applied to a switch having desired output voltage level characteristics.

A primary advantage of the present invention is that the circuit may be utilized to provide voltage translations which are predictable even though manufacturing process variables cause the various component elements to have slightly varying electrical characteristics.

Other objects and advantages of the present invention will no doubt become apparent to those skilled in the art after having read the following detailed description in the preferred embodiments which are illustrated in the several figures of the drawings.

## DESCRIPTION OF THE DRAWINGS

Figure 1 is a block diagram of a translator made in accordance with the invention.

Figure 2 is a detailed schematic diagram of a preferred embodiment of a TTL to ECL translator made in accordance with the invention.

## DETAILED DESCRIPTION OF THE PREFERRED EMBODIMENT

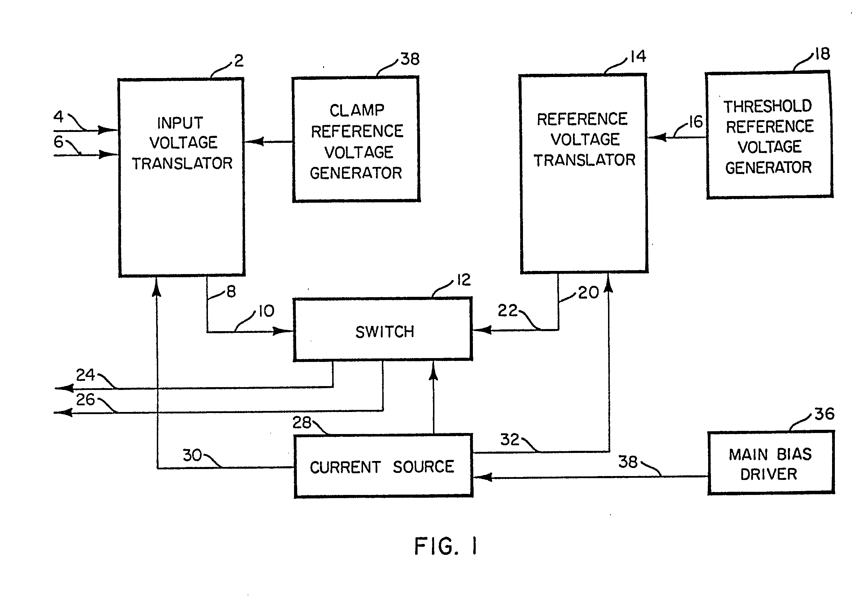

Referring to Figure 1, an input voltage translator 2 is coupled to receive input data and control signals of a first voltage level at inputs 4 and 6. The input voltage translator 2 translates the voltage level of the input signals applied at its inputs 4 and 6 and produces a translated voltage at its output 8. The input voltage translator output 8 is applied to the first input 10 of a switch 12. A reference voltage translator 14 is coupled to receive a threshold reference voltage 16 from a threshold reference voltage generator 18. The reference voltage translator 14 translates the reference voltage 16 to a new translated reference voltage and produces this translated reference voltage as an output 20. The output 20 is applied to a second input 22 of the switch 12. The switch 12 compares the levels of voltage appearing at its inputs 10 and 22 and produces an output at a selected voltage level at its outputs 24 and 26 in response to a comparison of the relative voltage levels of the voltages applied to its inputs 10 and 22.

The input voltage translator 2 and the reference voltage translator 14 are fabricated on the same integrated circuit chip by the same processing steps. Different processes known in the art may be used, the important feature being that for a selected process the same process steps are used to form both the input voltage translator 2 and the reference voltage translator 14. The input voltage translator 2 and the reference voltage translator 14 are designed to have the same number of forward biased diode voltage drops and base emitter voltage drops in their respective voltage translation chains. The input voltage translator 2 is driven by a current source 28 which produces an input voltage translator drive current 30. The reference voltage translator 14 is also driven by the current source 28 which produces a reference voltage translator drive current 32 equal to the input voltage translator drive current 30. The forward biased junctions of the translators 2 and 14 are matched in current density by equal current drive from the current source 28 and the selection of equal effective emitter areas for each junction. The switch 12 is also driven by the current source 28 which produces the switch drive current 34. The current source 28 is driven by a main bias driver 36. THe input voltage translator 2 is coupled to receive a clamp voltage 7 from a clamp reference voltage generator 38.

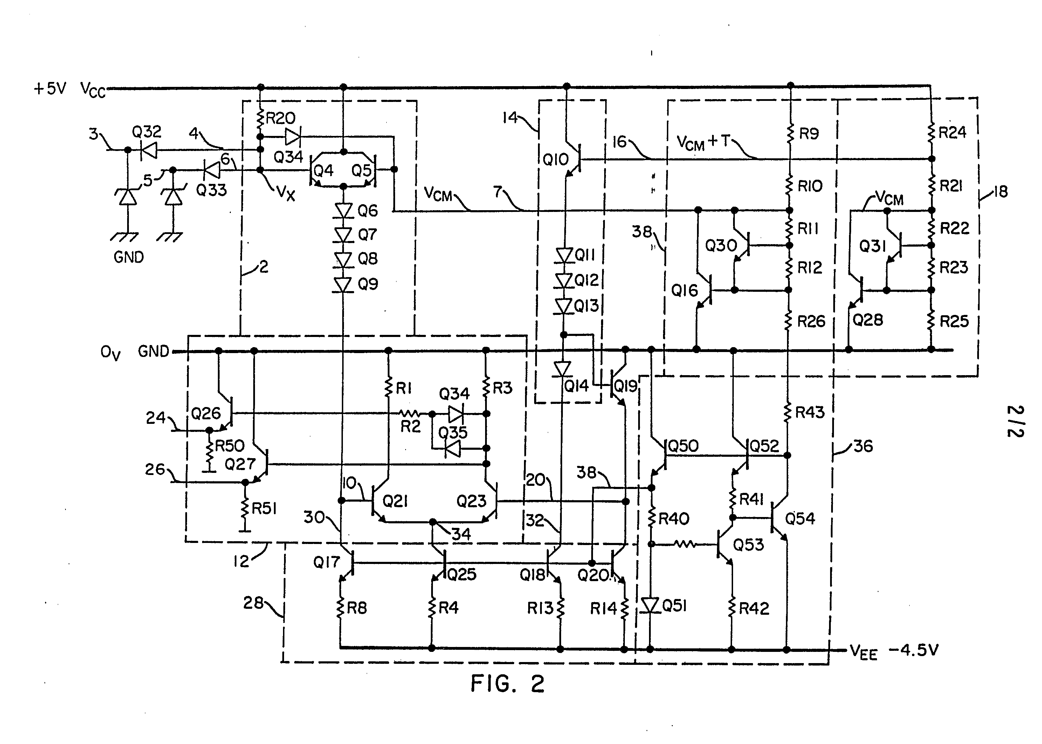

Referring to Figure 2, a detailed schematic diagram of a TTL to ECL translator built in accordance with the present invention is shown.

Referring to the upper left hand portion of Figure 2, TTL level inputs are applied at inputs 3 and 5. The preferred embodiment shown is designed to have a threshold of 1.4 volts, and is to be utilized with a high power supply having a $V_{CC}$ equal to 5 volts, a ground of 0 volts and a $V_{EE}$ of -4½ volts. A TTL level applied signal greater than 1.4 volts shall be referred to as high, and an applied signal having a voltage level less than 1.4 volts will be referred to as low. When the voltage levels applied at inputs 3 and 5 are high, the voltage shown as $V_X$ applied at the base of transistor Q4 within the input translator 2 will be equal to the sum of the clamp voltage 7, shown as $V_{CM}$, applied to the base of a transistor Q5 and the voltage drop across diode Q34 and transistor Q4 will be on and transistor Q5 will be off. When either input 3 or input 5 is low, then $V_X$ is equal to the input voltage applied plus the voltage drop across either diode Q32 or diode Q33 respectively, and transistor Q5 will be on and transistor Q4 will be off. When the clamp voltage $V_{CM}$ is greater than the voltage at the base of Q4, which is $V_X$, and the forward biased base emitter voltage drop of transistor Q4 is equal to the forward biased base emitter voltage drop of transistor Q5, it is clear that the voltage swing at the emitters of transistors Q4 and Q5 is limited to the voltage drop across diode Q34. The input voltages appearing at inputs 4 and 6 are translated down by the forward biased drop of the base emitter junction of Q4, the forward biased drop of diode Q6, the forward biased voltage drop of diode Q7, the forward biased diode voltage drop of diode Q8 and the forward bias diode voltage drop of diode Q9 to produce a translated voltage at output 8.

The clamp reference voltage generator 38 comprises transistor Q16, transistor Q30, resistor R9, resistor R10, resistor R11, resistor R12, and resistor R26. A clamp voltage $V_{CM}$ is equal to the forward biased base emitter voltage drop of transistor Q16 plus the collector emitter voltage of transistor Q30. The collector emitter voltage of transistor Q30 is defined by the forward biased base emitter voltage of transistor Q30. If the value of the base emitter voltage of transistor Q30 is divided by the value of the resistance of resistor R12, the current passing through resistors R11 and R12 is determined. By multiplying the value of the current times the total value of resistances of resistor R11 and resistor R12, the emitter and collector voltage of transistor Q30 is determined. The voltage value of the clamp voltage $V_{CM}$ is then determined by the emitter collector voltage of transistor Q30 plus the emitter base voltage of transistor Q16.

The threshold reference voltage generator 18 comprises transistor Q28, transistor Q31, resistor R24, resistor R21, resistor R22, resistor R23, and resistor R25. The operation of the threshold reference voltage generator 18 is similar to the operation of the clamp reference voltage generator 38 discussed above. The threshold reference voltage 16 is equal to the forward biased base emitter voltage drop of transistor Q28 plus the collector emitter voltage of Q31. By dividing the value of the base emitter voltage transistor Q31 by the resistance of R23, the current passing through resistor R22 and resistor R23 is defined. By multiplying this current with the total resistance value of resistor 22 and resistor 23, the emitter and collector voltage of transistor Q31 is determined. The threshold reference voltage 15 shown as $V_{CM + T}$ is therefore equivalent to the emitter-collector voltage of transistor Q31 plus the emitter and base voltage of transistor Q28.

The main bias driver 36 comprises transistors Q50, Q52, Q53, Q54, diode Q51 and resistors R41, R42, R43 and $R_X$. The main bias driver 36 is a temperature compensated voltage regulator circuit having a resistive impedance of a particular value disposed in the base circuit of transistor Q53 to provide compensation for possible Beta variations incurred as a result of process variables, and its operation and the selection of $R_X$ is disclosed in United States Patent #3,781,648 issued December 25, 1973 and said patent is hereby fully incorporated by reference. The main bias

F-1468

0052565

driver 36 produces a reference voltage 38 which is applied to the current source 28. The reference voltage 38 varies little with reference to temperature changes and changes in the supply voltage $V_{EE}$.

The reference voltage translator 14 comprises transistor Q10, diode Q11, diode Q12, diode Q13 and diode Q14. The threshold reference voltage 16 depicted as $V_{CM + T}$ from the threshold reference voltage generator 18 is translated down in voltage by the forward biased base emitter voltage drop of transistor Q10, the forward biased diode voltage drop of diodes Q11, Q12, Q13 and Q14. Although one embodiment which is not shown in Figure 2 would include coupling to the cathode of the diode Q14 as the reference voltage translator output 20, a preferred embodiment is shown wherein a transistor Q19 and a transistor Q20 are included in the circuit to provide improved stability during switching. The transistor Q19 provides an extra gain stage which provides current to the switch 12 drawn from the collector of Q19 rather than the diodes Q11, Q12, Q13, and the transistor Q10 to prevent possible detrimental effects in changing the forward biased voltage drop across all of them. If the current to drive the switch 12 were taken directly from the cathode of the diode Q14, there would be a relatively large surge of current required to charge parasitic capacitance at the base of the transistor Q23 within the switch 12 during a switch transition from transistor Q21 being on to transistor Q23 being on. The additional current being drawn would create a change in the forward biased voltage drops of diode Q11, diode Q12, diode Q13 and diode

F-1468
**0052565**

Q14 such that the speed of the switching will be actually slowed down. By using the transistors Q19 and Q20, the extra current is not derived through the diodes Q11, Q12, Q13 and Q14 but through the transistor Q19 and the only change in the voltage will be the minimal change in the forward biased base-emitter voltage drop of the transistor Q19.

The switch 12 is an ECL switch comprising transistors Q21, Q23, Q26, Q27, resistors R1, R2, R3, R50 and R51 and diodes Q34 and Q35.

The current source 28 is of conventional design and comprises NPN transistors Q17, Q18, Q20 and Q25 and resistors R4, R8, R13 and R14.

The translation by reference voltage translator 14 of the output voltage $V_{CM + T}$ from the threshold reference voltage generator 18 to the switch 12 and translation by the input voltage translator 2 of the voltage $V_X$ to the switch 12 influences how close the circuit will meet the desired switching threshold of 1.4V at the inputs 3 and 5. Referring to the switch 12 and the base of the transistor Q21, the voltage at the base of transistor Q21 will vary from $V_{CM} - 5V_{FB}$ to $V_{CM} + V_{34} - 5V_{FB}$ and the voltage at the base of transistor Q23 is $V_{CM + T} - 5V_{FB}$ where $V_{FB}$ is a forward biased base-emitter/diode voltage drop and $V_{34}$ is the voltage drop across diode Q34 in the input voltage translator 2. It is seen that the absolute value of $5 V_{FB}$ has no impact on the switching threshold if the current density is the same for the diode voltage drops on both side, the input voltage translator 2 side and the reference voltage translator 14 side, of the switch 12 and the junctions in each translator are subject to the same process and temperature variations.

The threshold reference voltage generator 18 output $V_{CM + T}$ is:

$$Eq\ (1)\quad V_{CM + T} = V_{CM} + \frac{(V_{CC} - V_{CM})}{R21 + R24}\ R21$$

The effect of variations on the reference voltage translator 14 will be examined and then compared with the effect of variations on the input voltage translator 2.

The variations of $V_{CM + T}$ with reference to changes in the supply voltage $V_{CC}$ is:

$$Eq\ (2)\quad \frac{d\ V_{CM + T}}{d\ V_{CC}} = \frac{R21}{R21 + R24}$$

The variation of $V_{CM + T}$ with reference to changes in temperature is:

$$Eq\ (3)\quad \frac{d\ V_{CM + T}}{d\ t} = \frac{d\ V_{CM}}{d\ t} - \frac{R21}{R21 + R24}\ \frac{d\ V_{CM}}{d\ t}$$

$V_{CM}$ is equal to:

$$Eq\ (4)\quad V_{CM} = V_{28} + V_{31}\ (1 + \frac{R22}{R23})$$

Where $V_{28}$ is the base-emitter voltage drop of transistor Q28, $V_{31}$ is the base-emitter voltage drop of transistor Q31, R22 is the resistance of resistor R22 and R23 is the resistance of resistor R23.

The variation of $V_{CM}$ with temperature is:

$$Eq\ (5)\quad \frac{d\ V_{CM}}{d\ t} = \frac{d\ V_{28}}{d\ t} + \frac{d\ V_{31}}{d\ t}\ (1 + \frac{R22}{R23})$$

Substituting Eq (5) into Eq (3):

$$Eq\ (6)\quad \frac{d\ V_{CM + T}}{d\ t} = \frac{R24}{R21 + R24} \left\{ \frac{d\ V_{28}}{d\ t} + \frac{d\ V_{31}}{d\ t}\ (1 + \frac{R22}{R23}) \right\}$$

The variation of $V_{CM + T}$ with reference to change in forward biased base-emitter/diode voltage drops due to process variation and the like is therefore:

Eq (7) $\quad \dfrac{d\,V_{CM + T}}{d\,V} = \dfrac{R24}{R21 + R24}\left(2 + \dfrac{R22}{R23}\right)$

At the point of switching transistion of transistor Q4 within the input voltage translator 2, the voltage at the base of transistor Q4 is:

Eq (8) $\quad V_{B4} = V_{in} + V_{32}$

Where $V_{B4}$ is the voltage at the base of transistor Q4, $V_{in}$ is a voltage applied to input 3 and $V_{32}$ is the voltage across diode Q32 at the point of switching of transistor Q4.

The variation of $V_{B4}$ with reference to $V_{CC}$ is:

Eq (9) $\quad \dfrac{d\,V_{B4}}{d\,V_{CC}} = 0$

The variance of $V_{B4}$ with reference to temperature, ignoring the minimal effects of variations in resistance to resistor R20, is:

Eq (10) $\quad \dfrac{d\,V_{B4}}{d\,t} = \dfrac{d\,V_{32}}{d\,t}$

The variation of $V_{B4}$ with reference to change in forward biased base-emitter/diode voltage drops due to process variation and the like is:

Eq (11) $\quad \dfrac{d\,V_{B4}}{d\,v} = 1$

Typical values for the circuit shown in Figure 2 are given in the table below:

## TABLE I

| | |
|---|---|
| R1, R2, R3 | 159 ohms |
| R4 | 64.2 ohms |
| R20 | 2500 ohms |
| R8, R13, R14 | 200.9 ohms |
| R9, R24 | 301.1 ohms |
| R10, R21 | 49 ohms |
| R11, R22 | 105.2 ohms |
| R12, R23 | 861 ohms |
| R26, R25 | 220 ohms |
| R40 | 122 ohms |
| $R_X$ | 100 ohms |
| R41 | 247.5 ohms |
| R42 | 38 ohms |
| R43 | 1970 ohms |

Using the above values in the derived equations:

From Eq (2) $\dfrac{d\,V_{CM\,+\,T}}{d\,V_{CC}} = .14$

Therefore, for one volt change in $V_{CC}$ the threshold voltage changes by only 140 mv.

From Eq (6):

$$\frac{d\,V_{CM\,+\,T}}{d\,t} = .86\,\frac{d\,V_{28}}{d\,t} + .97\,\frac{d\,V_{31}}{d\,t}$$

From Eq (9)

$$\frac{d\,V_{B4}}{d\,t} = \frac{d\,V_{32}}{d\,t}$$

and

$$\frac{d\,V_{32}}{d\,t} = \frac{d\,V_{28}}{d\,t} = \frac{d\,V_{31}}{d\,t} = \frac{d\,V}{d\,t}$$

since the base-emitter/diode junctions are formed on the same chip by the same processes and are operated at the same temperature and current density. The variation in threshold sensitivity with temperature is the variation in reference voltage translation minus the variations in input voltage translation or:

Eq (11)

$$\frac{d\ V_{TH}}{d\ t} = \frac{d\ V_{CM + T}}{d\ t} \doteq \frac{d\ V_{B4}}{d\ t} = 1.83\ \frac{dV}{dt} - \frac{dV}{dt} = .83\ \frac{dV}{dt}$$

$\frac{dV}{dt}$ has been measured to be approximately 1.5 mv/oC thereby yielding $\frac{d\ V_{TH}}{d\ t} = 1.2$ mv/oC for the embodiment described.

With reference to variations in threshold due to process variations, substituting values into Equation (7) for the variation during reference translation yields

$$Eq\ (12)\quad \frac{d\ V_{CM+T}}{d\ v} = .86 \times 2 + \frac{105.2}{861} = 1.825$$

Variation during input voltage translation from Equation (10) yields

$$Eq\ (13)\quad \frac{d\ V_{B4}}{d\ V} = 1$$

Defining total variation to be equal to variation in reference voltage translation minus variation in input voltage translation yields,

$$Eq\ (14)\quad \frac{\triangle\ V_{TH}}{\triangle\ V} = .825$$

The change in threshold voltage corresponding to a change in forward biased base-emitter/diode voltage of 50 mv, for example, is 41.25 mv for the circuit shown in Figure 2. Actual measured variations of circuits constructed as shown correspond to the predicted variations.

For the preferred embodiment shown in Figure 2, similar current density for forward biased junctions in the input voltage translator 2 and the reference voltage translator 14 were maintained by selection of effective emitter area and the input voltage translator drive current 30 and the reference voltage drive current 32. Table II below depicts
specific junctions and the selected emitter width and
emitter length in microns.

TABLE II

| Junctions | Emitter Width Times Emitter Length | |
|---|---|---|
| Q4, Q5, Q6, Q7, Q8, Q9, Q14, Q19 | 3 x 40 | CEB |
| Q10, Q11, Q12, Q13 | 3 x 43 | CEB |
| Q30, Q31 | 3 x 11 | Double Base |
| Q16, Q28 | 3 x 20 | Single Base |
| Q21, Q23 | 3 x 36 | Double Base |
| Q3, Q35 | 3 x 9 | Single Base |
| Q7, Q18, Q20 | 3 x 9 | Single Base |
| Q25 | 3 x 19 | Single Base |
| Q26, Q27 | (3 x 34) x 2 | Double Base |
| Q32, Q33, Q34 | (10 x 14) | |
| D2 | Schottky Clamp | |

1. Voltage level translation apparatus characterized by:

input voltage translator means having a selected number of serially connected forward biased junctions coupled to receive an applied input signal of a first voltage level for reducing the applied input signal to a second voltage level by an amount corresponding to the voltage drop across said selected number of serially connected forward biased junctions:

reference voltage translator means having said selected number of serially connected forward biased junctions coupled to receive an applied threshold reference signal at a third voltage level for reducing the reference signal to a fourth voltage level by an amount corresponding to the voltage drop across said selected number of serially connected forward biased junctions; and

means coupled to the input voltage translator means and the reference voltage translator means for matching the current density of said selected number of serially connected forward biased junctions in the input voltage translator means to the current density of said selected number of serially connected forward biased junctions in the reference voltage translator means.

2. Apparatus as in claim 1 characterized by means coupled to receive the second voltage level and the fourth voltage level for producing an output in response to comparing the relative voltage levels of the second voltage level and the fourth voltage level.

3. Apparatus as in claim 1 or 2 characterized in that each of said selected number of serially connected forward biased junctions in the input voltage translator means has an effective emitter area substantially similar to the effective emitter area of each of said selected number of serially connected forward biased junctions in the reference voltage translator means; and

means for matching the current density comprises a current source coupled to supply substantially equal current to the serially connected forward biased junctions in the input voltage translator means and to the serially connected forward biased junctions in the reference voltage translator means.

4. Apparatus as in claim 1, 2 or 3 characterized in that input voltage translation apparatus comprise:

a first transistor having a base coupled to receive the applied input signal, a collector coupled to receive an applied bias and an emitter; and

a first plurality of serially connected diodes coupled to the first transistor emitter and disposed so that each of the first plurality of serially connected diodes is forward biased when the base-emitter junction of the first transistor is forward biased.

5. Apparatus as in claim 4 characterized in that reference voltage translator means comprise:

a second transistor having a base coupled to receive the applied threshold reference signal, a collector coupled to receive an applied bias and an emitter; and

a second plurality of serially connected diodes coupled to the second transistor emitter and disposed so that each of the second plurality of serially connected diodes is forward biased when the base-emitter junction of the second transistor is forward biased, the number of the second plurality being equal to the number of the first plurality.

6. Apparatus as in claim 5 characterized in that the input voltage translator means comprise

a third transistor having a collector coupled to the first transistor emitter and a base coupled to receive an applied clamp reference voltage; and

a diode coupled between the first transistor base and the second transistor base.

7. Apparatus as in claim 2 characterized in that means for producing an output comprise a differential switch.

8. Apparatus as in any one of the previous claims, characterized in that the input voltage translator means and the reference translator means are formed by the same process steps within the same integrated circuit.

FIG. 1

FIG. 2

| European Patent Office | EUROPEAN SEARCH REPORT | Application number |
|---|---|---|
| | | EP 81 40 1793 |

## DOCUMENTS CONSIDERED TO BE RELEVANT

| Category | Citation of document with Indication, where appropriate, of relevant passages | Relevant to claim |
|---|---|---|
| | IBM TECHNICAL DISCLOSURE BULLETIN, vol. 12, no. 2, July 1969, New York, US TAYLOR et al. "Logic signal shift circuit", page 296. <br><br> * Figure; page 296 * | 1-5,7 |
| | IEEE JOURNAL OF SOLID STATE CIRCUITS, vol. SC-9, no. 5, October 1974, New York, US WOOLEY et al. "An integrated m out of n detection circuit using threshold logic", pages 297-306. <br><br> * Figures 6,7,8,9,10; from page 300, right-hand column line 11 to page 304, left-hand column, line 4 * | 1-8 |
| | US - A - 3 546 484 (FOWLER) <br><br> * Figure 1; from column 1, line 1 to column 6, line 39 * | 1-8 |
| A | US - A - 3 959 666 (FETT et al.) <br><br> * Figures 1,2,3; from column 2, line 34 to column 4, line 22 * | 1-5 |

### CLASSIFICATION OF THE APPLICATION (Int. Cl. ³)

H 03 K 19/092

### TECHNICAL FIELDS SEARCHED (Int.Cl. ³)

H 03 K 19/092
19/086
5/02
17/60

### CATEGORY OF CITED DOCUMENTS

X: particularly relevant if taken alone
Y: particularly relevant if combined with another document of the same category
A: technological background
O: non-written disclosure
P: intermediate document
T: theory or principle underlying the invention
E: earlier patent document, but published on, or after the filing date
D: document cited in the application
L: document cited for other reasons

&: member of the same patent family, corresponding document

| | The present search report has been drawn up for all claims | | |
|---|---|---|---|
| Place of search | Date of completion of the search | Examiner | |
| The Hague | 26-01-1982 | FEUER | |